(19)

**Europäisches Patentamt**
**European Patent Office**
**Office européen des brevets**

(11) **EP 1 722 213 B1**

(12) **EUROPEAN PATENT SPECIFICATION**

(45) Date of publication and mention
of the grant of the patent:
**16.10.2019 Bulletin 2019/42**

(51) Int Cl.:
**G01N 21/21** (2006.01)
**G01N 13/00** (2006.01)
**G01N 15/08** (2006.01)
**H01L 21/66** (2006.01)

(21) Application number: **05015412.9**

(22) Date of filing: **15.07.2005**

(54) **Method for the quantification of hydrophilic properties of porous materials**

Verfahren zur Quantifizierung der hydrophilen Eigenschaften poröser Materialien

Procédé pour la quantification des proprietés hydrophiles d'un materiau poreux

(84) Designated Contracting States:
**AT BE BG CH CY CZ DE DK EE ES FI FR GB GR HU IE IS IT LI LT LU LV MC NL PL PT RO SE SI SK TR**

(30) Priority: **12.05.2005 US 680665**

(43) Date of publication of application:
**15.11.2006 Bulletin 2006/46**

(73) Proprietor: **IMEC VZW**
**3001 Leuven (BE)**

(72) Inventors:
• **Baklanov, Mikhail**
**B-3020 Veltem-Beisem (BE)**
• **Le, Quoc Toan**
**B-5001 Belgrade (Namur) (BE)**
• **Mogilnikov, Konstantin Petrovich**
**630055 Novosibirsk (RU)**

(74) Representative: **DenK iP**
**Leuvensesteenweg 203**
**3190 Boortmeerbeek (BE)**

(56) References cited:
**US-A1- 2002 022 378     US-B1- 6 208 014**

• **GALINDO R E ET AL: "Systematic positron study of hydrophilicity of the internal pore surface in ordered low-k silica thin films" MATERIALS SCIENCE AND ENGINEERING B, ELSEVIER SEQUOIA, LAUSANNE, CH, vol. 102, no. 1-3, 15 September 2003 (2003-09-15), pages 403-408, XP004450769 ISSN: 0921-5107**

• **REVOL P ET AL: "Porosimetry Measurements on Low Dielectric Constant-Thin Layers by Coupling Spectroscopy Ellipsometry and Solvent Adsorption-Desorption" JOURNAL OF POROUS MATERIALS, vol. 12, no. 2, April 2005 (2005-04), pages 113-121, XP002363086 Netherlands**

• **C Wongmanerod ET AL: "Determination of pore size distribution and surface area of thin porous silicon layers by spectroscopic ellipsometry", Applied Surface Science, 1 January 2001 (2001-01-01), pages 117-125, XP055051826, Retrieved from the Internet: URL:http://144.206.159.178/ft/68/31895/140 40752.pdf [retrieved on 2013-01-31]**

• **F. N. Dultsev: "Nondestructive Determination of Pore Size Distribution in Thin Films Deposited on Solid Substrates", Electrochemical and Solid-State Letters, vol. 2, no. 4, 1 January 1999 (1999-01-01) , page 192, XP055051833, ISSN: 1099-0062, DOI: 10.1149/1.1390780**

• **KONDOH E ET AL: "Effect of oxygen plasma exposure of porous spin-on-glass films", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 18, no. 3, 1 May 2000 (2000-05-01), pages 1276-1280, XP012008187, ISSN: 0734-211X, DOI: 10.1116/1.591374**

• **BOURGEOIS A ET AL: "Description of the porosity of inhomogeneous porous low-k films using solvent adsorption studied by spectroscopic ellipsometry in the visible range", THIN SOLID F, ELSEVIER, AMSTERDAM, NL, vol. 455-456, 1 May 2004 (2004-05-01), pages 366-369, XP004504809, ISSN: 0040-6090, DOI: 10.1016/J.TSF.2003.11.229**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical field of the invention

The present invention is related to a method for the quantification of hydrophilic properties of porous materials, for example, low-k materials having pores. The method according to the invention may also be used for determining depth of damage of such porous materials after patterning.

### Background of the invention

The most critical issue in integration of porous materials, such as e.g. low-k materials, during semiconductor processing is the degradation of e.g. their dielectric properties during plasma etching and/or resist stripping. The plasmas used during such processes typically comprise oxygen-containing species. The main reason of degradation of the dielectric properties of porous materials is the removal of carbon containing hydrophobic groups by using these oxygen containing plasmas.

Carbon depletion occurs when, for example, a $Si-CH_3$ bond is broken and the carbon is replaced by a silicon-dangling bond. This carbon depletion results in the formation of silanol (Si-OH) through a variety of intermediate reactions. This leads to an increase in k-value for the damaged portion of the porous material and converts the inherently hydrophobic low-k material into a hydrophilic material. Subsequent adsorption of moisture, e.g. water, or other polar molecules having high polarisability, mediated by hydrogen bonding, can significantly increase the effective k-value of the material, e.g. to a k-value >> 80. Degree and depth of plasma damage depends on the pore size and the pore connectivity of the porous material and therefore, ultra low-k materials with e.g. k-value lower than 2.6, which normally have a relatively large pore size, suffer much stronger from this plasma damage than micro-porous materials with a k-value of higher than 2.6. The extent of the damaged portion of the dielectric material at sidewalls of etched is also expected to increase as the porosity of the porous material increases, and the weight of such damage on overall electrical performance gains importance as the spacing between interconnect lines shrinks. Therefore, sidewall dielectric damage has a major impact on the performance of advanced interconnects, and a reliable analysis method for evaluating the extent of such damage would be appreciated.

In general, the depth and profile of carbon depletion is evaluated using complicated analytical techniques like, for example, Time-of-Flight Secondary Ion Mass Spectroscopy (TOF-SIMS), X-ray photoelectron spectroscopy (XPS), Energy Filter transmission Electron microscopy (EFTEM) etc., or by using the so called HF-dip test. TOF-SIMS is a type of SIMS in which an ultra-low current incident ion beam is used and by which information regarding chemical composition of the outermost surface of solids can be obtained. EFTEM is a technique that detects the variation of the atomic concentrations of elements such as C, O and Si through the cross-section of a feature.

Using TOF-SIMS, it is assumed that only the carbon concentration is responsible for the hydrophobic properties that finally define the dielectric constant of the film, independent of how they are bonded and integrated in the porous material structure. TOF-SIMS data for determination the depth of low-k damage are related to the carbon concentration in the surface region of the low-k porous material and these data are compared with the carbon concentration in the bulk of the low-k material. The carbon depletion in the surface region after etching and stripping is then an indication of the low-k damage. However when such low-k materials, e.g. films, are subjected to HF dip test there is no clear correlation between carbon depletion and plasma damage.

A HF dip test is based on the fact that damaged low-k dielectric material shows a higher etch rate than undamaged material. Normally this test more directly reflects the hydrophilic properties of the porous material but an autocatalytic mechanism of interaction of HF with $SiO_2$ makes this test not reliable because the etch rate and the calculated depth of damage depends on the HF concentration.

Carbon depletion cannot always directly be correlated with plasma damage. For example, when a highly polymerizing chemistry is used (e.g. $C_xF_yH_z$ plasma), the carbon depletion is compensated by the deposition of $CF_x$ polymers resulting in equal or increased carbon concentrations in the low-k porous material surface. According to traditional interpretation of TOF-SIMS results, this surface should be the most hydrophobic (no "damage"). However, HF dip tests show a larger etch rate of this sample in comparison with an undamaged low-k reference material, which in general is pristine [Quoc Toan Le et al., Electrochem.Sol.-St.Lett., 8 (7) F21 (2005)]. Therefore, the fluorocarbon polymer that is formed during the etching process and that fills the pores of the porous material is not able to provide the same hydrophobic properties as the original hydrophobization agents. These facts show the importance for the development of special measurement procedures that gives more direct analysis on the degree of internal hydrophilization related to plasma damage.

In addition, all the existing methods described above and other methods available in the prior art are destructive and/or very complicated and do not give information directly correlated with loss of hydrophobicity, which has the largest effect on the dielectric properties of the porous material. Thus, the prior art proposes several methods to determine low-k damage but all of them do have serious drawbacks and shortcomings. There is no method available in the prior art that allows to determine the depth of damage and exact hydrophobicity of the low-k material. There is a need for such a method and a need for having a simple non-destructive method in further exploring and screening different low-k materials, especially for ultra low-k materials used for future technologies.

A. Bourgeois et al. "Description of the porosity of inhomogeneous porous low-k films using solvent adsorption studies by spectroscopic ellipsometry in the visible range", Thin Solid Films 455-456 (2004) p. 366-369; and F.N. Dultsev et al. "Nondestructive determination of pore size distribution in thin films deposited on solid substrates", Electrochemical and Solid-State Letters, 2(4) (1999) p.192-194 disclose applications of ellipsometric porosimetry.

**Summary of the invention**

It is an object of the present invention to provide a non-destructive method for the quantification of hydrophilic properties of a porous material.

The above objective is accomplished by a method according to claim 1.

The present invention provides a method for the quantification of hydrophilic/hydrophobic properties of a porous material, these hydrophilic/hydrophobic properties being a measure for the degree of damage of a porous material. Preferably said material is a porous low-k material and most preferred said material is an ultra low-k material. The method makes use of adsorption/desorption characteristics within the pores of the porous material. Furthermore making use of first and second adsorptives with different contact angle (also referred to as wetting angle) towards an inner surface of the pores of the porous material, the method according to the invention allows to determine the hydrophilic/hydrophobic properties of the porous material.

The first adsorptive is an adsorptive with a contact or wetting angle substantially equal to zero and the second adsorptive is an adsorptive with a contact or wetting angle which is 90° or higher with regard to the porous material, having polar properties. Examples of first adsorptives (with substantially zero contact angle towards low-k materials and porous membranes comprising organic molecules) are nitrogen, toluene, methanol and benzene; these adsorptives show good wettability with porous materials, e.g. low-k materials. Examples of the second adsorptives (with contact angle of 90° or higher towards low-k materials and porous membranes comprising organic molecules) are water, thionyl ($SOCl_2$) or any other suitable inorganic solvent having a contact angle of 90° or higher towards low-k materials and porous membranes comprising organic molecules.

The method according to the present invention thus is a method as defined in claim 1.

Hence, according to the method according to the invention, to determine the hydrophilic/hydrophobic properties of a porous material, e.g. a low-k film having pores, at least two ellipsometric measurements with use of the first and second adsorptive are required. Most preferred these ellipsometric measurements are ellipsometric measurements at pressures changing between zero and the equilibrium vapour pressure of the adsorptives used. To perform these ellipsometric measurements a substrate having the porous material, e.g. a low-k film, on top of it is located in a pressurizable chamber subsequently filled with the first and second adsorptive or gaseous substance.

With substantially zero is meant that the first contact or wetting angle may be lower than 5°, preferably lower than 3° and most preferably lower than 1°. The second contact angle is equal or higher than 90°.

According to an embodiment of the present invention, a method is disclosed to determine the degree of damage to a porous material, e.g. a low-k material, and more specifically to determine the internal surface energy (effective contact angle), degree and depth of damage within the porous material, e.g. low-k material. Damage is defined here as loss of hydrophobicity of the porous material, e.g. low-k material, that is related to plasma etch and/or strip processes. More specifically a method is disclosed comprising at least three ellipsometric measurements. Most preferred these ellipsometric measurements are ellipsometric adsorption measurements. According to this embodiment of the invention, again a first and second adsorptive are used, each having a different wetting angle with respect to an inner surface of the pores of the porous material. The first adsorptive is an adsorptive with a contact or wetting angle towards the porous materials which is substantially equal to zero and the second adsorptive is an adsorptive with a contact (wetting) angle towards the porous material which is 90° or higher, and having polar properties. With substantially equal to zero is meant that the first contact or wetting angle may be lower than 5°, preferably lower than 3° and most preferably lower than 1°. To perform the (at least three) ellipsometric measurements a substrate having the porous material, e.g. low-k film, on top of it is located in a pressurizable chamber subsequently filled with the first and second adsorptive or gaseous substance at pressures changing between zero and the equilibrium vapour pressure of said gaseous adsorptives.

According to this second embodiment of the invention, the method may, next to the steps of the method described in the first embodiment, furthermore comprise:

- performing a third ellipsometric measurement on the porous material before damage treatment using the second adsorptive having a second wetting angle toward the porous material.

For the first ellipsometric measurement performed on the porous material, e.g. low-k film, a first gaseous adsorptive is used having a contact or wetting angle towards the porous material which may be substantially equal to zero such that the porosity of the porous material, e.g. low-k film, can be obtained. Examples of the first adsorptive with contact or wetting angle substantially equal to zero are nitrogen, toluene, methanol and benzene; these adsorptives show good wettability with porous materials, e.g. low-k materials.

For the second ellipsometric measurement performed on the porous material, e.g. low-k film, the second adsorptive or gaseous substance is used which has polar molecules such that the hydrophilic/hydrophobic properties within the pores of the porous material, e.g. low-k film, can be obtained. Example of the second adsorptive (with contact angle towards the porous material of 90° or higher) may be water, thionyl ($SOCl_2$) or any other suitable inorganic solvent having a contact angle of 90° or higher towards low-k materials and porous membranes comprising organic molecules.

The third ellipsometric measurement is performed on a reference porous material, e.g. the porous material before damage treatment or a reference low-k film, with almost no hydrophilic properties. Often pristine is used for the reference material. The third ellipsometric measurement also makes use of the second gaseous adsorptive having polar molecules such that the intrinsic hydrophilic properties within the pores of the reference material, e.g. a reference low-k film, can be obtained.

In a preferred embodiment the method is used to determine the damage of porous materials, e.g. low-k films, after dry etch and strip processing.

Preferably this low-k material is a SiOC(H) material and most preferred the low-k material is an ultra low-k material having pore sizes 2 to 10 nm.

In embodiments according to the invention, the quantification of the hydrophobicity of the porous material may be used for determining the depth of damage caused to the porous material by an etch or stripping process.

Particular and preferred aspects of the invention are set out in the accompanying independent and dependent claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 shows TOF-SIMS data for atomic concentration of carbon as a function of time for a SiOC(H) low-k material after etching with a $CF_4$ comprising plasma, a $C_4F_8$ comprising plasma at low power, a $C_4F_8$ comprising plasma at intermediate power and a $C_4F_8$ comprising plasma at high power (PRIOR ART).

Fig. 2 and 3 illustrate the principle of an ellipsometric measurement.

Fig. 4 shows the adsorption/desorption cycle of toluene for a (damaged) low-k film, the adsorption/desorption cycle of water vapour for a (damaged) low-k film and the adsorption/desorption cycle of water vapour for a reference material pristine.

Figs. 5A to 5E show adsorption/desorption isotherms for (A) pristine, (B) a SiOC(H) low-k material (NCS) after $CF_4/O_2$ plasma etch, (C) a SiOC(H) low-k material (NCS) after $C_4F_8$ plasma etch, (D) a SiOC(H) low-k material (NCS) after $CF_4$ standard plasma etch, (E) a SiOC(H) low-k material (NCS) after hexamethyldisilizane (HMDS) treatment.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the invention as defined by the appended claims.

During particular steps, such as etching and/or stripping steps, of the manufacturing of devices comprising porous materials, the porous materials may be damaged. Porous materials, for example porous low-k films, may loose organic hydrophobic groups during plasma etch and/or strip processes. As a result, they become hydrophilic and they adsorb moisture and other polar molecules that drastically decrease their dielectric properties. The degree of plasma damage introduced to the porous material, e.g. low-k material, during these plasma etch and/or strip processes may be evaluated by using state of the art techniques such as e.g. depth-profile analysis using XPS, TOF-SIMS, EFTEM or others. In these methods, plasma damage is correlated with carbon depletion. However, as already discussed before, carbon depletion cannot always be directly correlated with plasma damage. For example, when a highly polymerizing plasma is used such as a e.g. $C_xF_yH_z$ plasma, the carbon depletion is compensated by the deposition of $CF_x$ polymers but the porous material has different properties in comparison with an undamaged reference porous material, e.g. porous low-k material. Often pristine material is used as undamaged reference low-k material. An alternative state of the art method is a HF dip test that is based on the fact that plasma damage has a correlation with the depth of etching. The HF etch depth, however, strongly depends on HF concentration because of auto catalytic etch mechanism of Silica by HF.

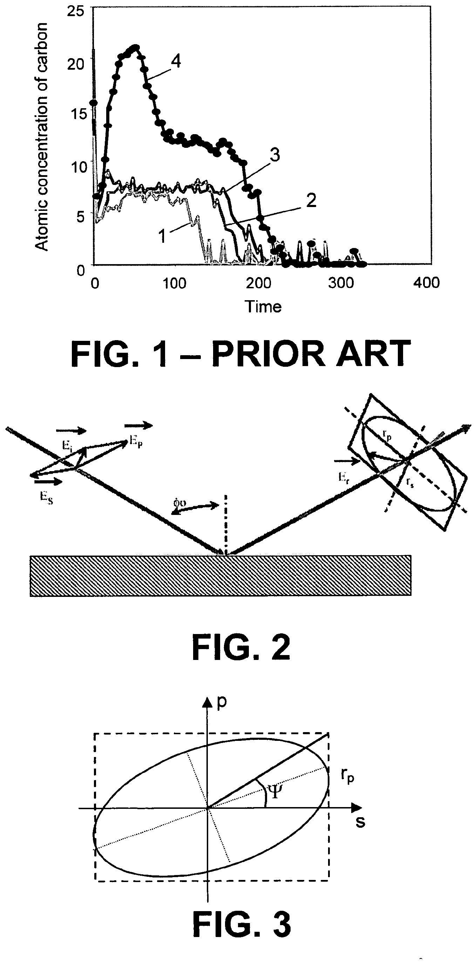

Fig. 1 shows TOF-SIMS data for the atomic concentration of carbon as a function of etching, e.g. ion sputtering time, which is proportional to depth of etching for a SiOC(H) low-k material after etching with a $CF_4$ comprising plasma (curve 1), a $C_4F_8$ comprising plasma at low power (e.g. 300 W at 27 MHz and 600 W at 2 MHz) (curve 2), a $C_4F_8$ comprising plasma at intermediate power (e.g. 800 W at 27 MHz and 1800 W at 2 MHz) (curve 3) and a $C_4F_8$ comprising plasma at high power (1000 W at 27 MHz and 2000 W at 2 MHz) (curve 4) [G. Mannaert et al., 'Minimising plasma damage and in situ sealing of ultra low-k dielectric films by using of oxygen free fluorocarbon plasma', J. Vac. Sci. Technol. B23(5), 2005]. It can be seen that a $CF_4$ based plasma (curve 1) gives rise to the most significant carbon depletion in the surface region. High power $C_4F_8$ based plasma (curve 2) also shows decrease in carbon concentration, but to a lower extent, in the surface region of the low-k material. According to TOF-SIMS interpretation of the results, this corresponds to a decrease in the depth of damage. Intermediate power $C_4F_8$ based plasma (curve 3) shows a small surface region indicating a decrease in carbon concentration and some enrichment of carbon concentration. Low power $C_4F_8$ based plasma (curve 4) shows a significant increase of carbon concentration in the surface region and bulk of the low-k material, especially in the region that corresponds to 30-50 nm from the top surface of the film. This can be determined from the fact that the depth of etching is proportional to the time of etching, e.g. ion sputtering. If the film thickness and the time of etching are known, the depth of etching can be calculated as a function of time, assuming that the etch rate is constant.

However, the observation of the increase of the carbon concentration in the damaged material, which is normally higher compared to the carbon concentration in a non-damaged material, in the example given pristine, reference material, is not related to the carbon concentration of the original SiOC(H) material (NCS (Nanocrystalline Silica) from CCIC, Japan, with initial porosity of 31%) but is caused by $CF_x$ polymers, also referred to as hydrofluorocarbon polymers, deposited during etching. According to the traditional interpretation of TOF-SIMS results, this material should be the most hydrophobic (no "damage"). However, a HF dip test shows larger etch rate of this sample in comparison with the reference pristine sample. The deposited $CF_x$ polymers tend to increase the k-value of the low-k material or at least change the material properties from hydrophobic (original material) towards hydrophilic. Therefore the fluorocarbon polymer that is formed during the etching process and that fills the pores of the porous material is not able to provide the same hydrophobic properties as the original hydrophobic groups which are lost during the etching process.

These facts show the importance for the development of a special measurement procedure that gives more direct information on the degree of internal hydrophilization of a porous material, for example low-k material, and more specifically the hydrophilization within the pores of the porous material, e.g. the low-k material.

Therefore, the present invention provides a method for the determination of hydrophilic and/or hydrophobic properties of porous materials, such as e.g. low-k materials. The method according to the invention may also be used for the quantification of damage or determining the depth of damage in porous materials, e.g. low-k materials, caused during particular steps during processing, e.g. etching and/or stripping steps. The method of the present invention may also be used for determining the hydrophobic/hydrophilic properties of porous membranes (e.g. zeolite), for example to determine the humidity of air in which they need to be stored. It will be appreciated that there are numerous variations and modifications possible. Accordingly, the description should not be deemed to limit the scope of the invention, which is defined by the claims.

Hereinafter, the invention will mainly be described by means of low-k materials. It has, however, to be understood that this is only for the ease of explanation and is not intended to be limiting the invention. The method according to the invention may also be applied to other porous materials such as, for example, porous membranes (e.g. zeolite membranes).

In a first embodiment according to the invention, a method is provided for the determination of hydrophilic and/or hydrophobic properties of a porous material, such as e.g. low-k materials or porous membranes. Preferably the porous material may be a porous low-k material and most preferably the porous material may be an ultra low-k material.

The method according to first embodiment of the invention makes use of adsorption and/or desorption characteristics within the pores of the porous material. By furthermore performing different ellipsometric porosimetry measurements, hereinafter referred to as ellipsometric measurements, while making use of different adsorptives or gaseous substances having different contact angles (also referred to as wetting angles) towards the porous material, it becomes possible to determine the hydrophilic/hydrophobic properties of the porous material.

Ellipsometric porosimetry measurements are based on analysis of hysteresis loops that appear due to processes of capillary condensation in adsorption and desorption of vapour out of pores of a porous material. The hysteresis loops appear because the effective radius of curvature of a condensed liquid meniscus is different during the adsorption and desorption processes. The adsorptive vapour condenses in pores of the porous material even if the vapour pressure P is less than the equilibrium pressure of a flat liquid surface $P_0$. Dependence of the relative pressure $P/P_0$ on the meniscus curvature is described by the Kelvin equation:

$$\frac{1}{r_1} + \frac{1}{r_2} = -\frac{RT}{\gamma V_L} \ln\left(\frac{P}{P_0}\right) \qquad (1)$$

wherein $\gamma$ and $V_L$ respectively are the surface tension and the molar volume of the adsorptive or gaseous substance used. The principal curvature radii $r_1$ and $r_2$ (elliptic radii) define pore sizes. In the case of cylindrical pores, $r_1 = r_2$ and equation (1) may be written as:

$$\ln\left(\frac{P}{P_0}\right) = -\frac{\gamma V_L}{RT}\left(\frac{2}{r_k}\right) \qquad (2)$$

wherein $r_k$ is often called the Kelvin radius.

The Kelvin equation (2) directly gives the pore radius, considering that the wetting angle of the adsorptive or gaseous substance with respect to the surface of the porous material is equal to zero. However, according to the invention, adsorptives or gaseous substances with different contact or wetting angles with respect to the porous material are used, and thus the contact or wetting angle has to be taken into account. Therefore, equation (2) becomes:

$$\ln\left(\frac{P}{P_0}\right) = -\cos\theta * \frac{\gamma V_L}{RT} * \left(\frac{2}{r_k}\right) \qquad (3)$$

wherein $\theta$ is the contact or wetting angle of the adsorptive or gaseous substance with respect to the porous material and $r_k$ is the average radius of the pores present in the porous material.

The ellipsometric porosimetry measurement technique is reviewed in "The Optics Source Book", Editor Sybil P. Parker, 1988, McGraw-Hill. The ellipsometric measurements are performed using single or multiwave length ellipsometry.

The initial experimental data for the calculation of the adsorption isotherm are the ellipsometric characteristics $\Delta$ (phase difference between p-polarised and s-polarised light (see Fig. 2)) and $\Psi$ (illustrated in Fig. 3), as ellipsometric measurements are normally expressed in terms of these parameters:

$$\tan(\Psi)e^{i\Delta} = \rho = \frac{r_p}{r_s} \qquad (4)$$

wherein $r_p$ and $r_s$ are the complex Fresnel reflection coefficients of the sample for p- (in the plane of incidence) and s- (perpendicular to the plane of incidence) polarised light (see Fig. 2). Special software, developed at the Institute of Semiconductor Physics in Novosibirsk, Russia, then allows for the calculation of the change of the refractive index of the porous material during adsorption and desorption. The change of adsorptive volume, or the pore volume, is then calculated from the change of refractive index using the following equation:

$$V = 1 - \frac{B_p}{B_b} = 1 - \left[ \frac{\left( n_p^2 - 1 \right)}{\left( n_p^2 + 2 \right)} \right] \Big/ \left[ \frac{\left( n_b^2 - 1 \right)}{n_b^2 + 2} \right] \qquad (5)$$

wherein $n_b$ is the refractive index of the dense part, i.e. the matrix, of material with volume polarisability $B_b$, $n_p$ is the measured refractive index of the pores and $B_p$ is the volume polarisability calculated from $n_p$. The dependence of the adsorptive volume on the relative pressure $P/P_0$ results in an adsorption isotherm.

As already described above, the method according to the first embodiment of the invention makes use of two different adsorptives or gaseous substances, i.e. a first adsorptive or gaseous substance with a first contact or wetting angle with respect to the surface of the porous material to be examined and a second adsorptive or gaseous substance with a second contact or wetting angle with respect to the surface of the porous material to be examined. According to the invention, the first contact or wetting angle is different from the second contact or wetting angle. According to the first embodiment of the invention, the first wetting angle is substantially equal to zero. With substantially equal to zero is meant that the first wetting angle may be smaller than 5°, preferably smaller than 3°and most preferable smaller than 1°. Preferably the difference between the first and second contact or wetting angle may be as high as possible. The second contact or wetting angle is 90° or higher.

Examples of adsorptives with a contact or wetting angle substantially equal to zero with respect to low-k materials or to porous membranes comprising organic molecules which may be used according to the invention may be e.g. nitrogen, toluene, methanol and benzene. In this case, $\cos\theta$ = 1 (because 0 = 0) in the Kelvin equation (3) and the adsorption/desorption cycle allows to calculate the volume of adsorbed adsorptive in the pores of the porous material which then corresponds to the volume of open pores present in the porous material, using the method as described above. Examples of adsorptives with a contact angle of 90° or higher with respect to low-k materials or to porous membranes comprising organic molecules may be water, thionyl ($SOCl_2$), or any other suitable inorganic solvent having a contact angle of 90° or higher towards low-k materials or porous membranes comprising organic molecules.

To perform the ellipsometric measurements a substrate having the porous material, e.g. a low-k film, on top of it is located in a pressurizable chamber filled with the first adsorptive or gaseous substance. Thereafter, the second measurement is performed in the same way but now in a pressurizable chamber filled with the second adsorptive or gaseous substance.

Hereinafter, the method according to the first embodiment of the invention will be further explained by means of an example. It has to be understood that this example is not limiting the invention. The method according to the invention may be applied to any porous material such as low-k materials or porous membranes having any degree of porosity.

In the following example, the hydrophilic/hydrophobic properties of a low-k material will be determined. In a first step, a first ellipsometric measurement is performed using e.g. toluene as a first adsorptive. From the measured values of W and A the change of refractive index n of the porous material is determined and from that change of refractive index n the change of adsorbed volume of toluene is determined, using the method as described above.

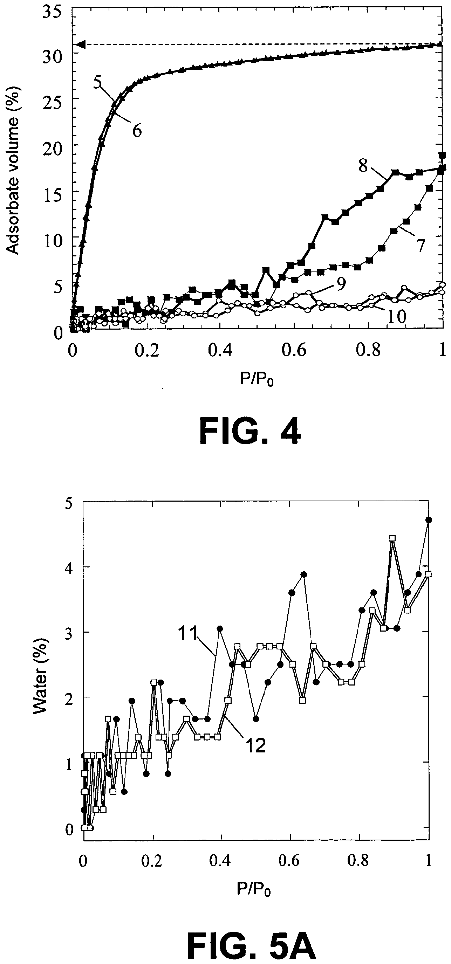

In Fig. 4 the adsorption/desorption cycle of toluene (respectively curve 5 and 6) for the low-k film of the example given is shown. From curves 5 and 6 it can be determined that the low-k film of the example given in Fig.4 has a porosity of about 31%. This porosity value is determined by the amount of adsorptive adsorbed in the pores of the porous material at a relative pressure $P/P_0$ equal to one or at a pressure $P = P_0$. At this pressure, the adsorptive or gaseous substance is fully condensed into the pores of the porous material, in the example given, in the pores of the low-k material. Therefore, the amount of adsorbed adsorptive equals the amount of pores present in the porous material, in the example given in the low-k material.

It has to be noted that the first step may be performed on at least one of a damaged or an undamaged porous material. Advantageously, the first measurement may be performed to both the undamaged (before processing) and the damaged (after processing) material, because it can occur that processing results in formation defects which may act as pores. Because of that, the porosity of the porous material can increase during processing. In that way, the porosity of the starting material can be determined as well a correct determination of damage caused by the processing steps.

In a second step, the damaged material is submitted to a second ellipsometric measurement using a second adsorptive or gaseous substance with a contact or wetting angle of 90° or higher with respect to the porous material.

Undamaged low-k dielectrics are, in general, hydrophobic which means that in the Kelvin Equation (3) $\cos\theta$ is close to zero when a polar adsorptive having a contact or wetting angle substantially different from zero with respect to the porous material, in the example given the low-k material, such as, for example, water, is used. Hence, in the case of water as an adsorptive, substantially no water condensation will occur in these porous materials, e.g. low-k films. From the second ellipsometric measurement the values for $\Psi$ and $\Delta$ are determined, from which subsequently the change in refractive index of the porous material, in the example given the low-k material, and the change in the amount of adsorbed water are determined, using the method as described above. Fig. 4 furthermore shows the adsorption/desorption cycle of water vapour for a damaged low-k film (respectively curve 7 and 8). From these curves 7, 8 an amount of adsorbed water of about 18,5% is determined. This value is determined by determining the adsorbed water volume at a pressure of $P = P_0$ (or $P/P_0 = 1$). From the amount of adsorbed water, the concentration of damaged centres can be calculated as follows. From the percentage of adsorbed water, the volume of adsorbed water can be determined. By multiplying the volume of adsorbed water with the density of water, the weight of adsorbed water is obtained. Dividing by the molecular weight of water yields the amount of moles adsorbed water. By multiplying this result with the Avogadro number, the number of centres to which water is adsorbed is achieved.

Furthermore, Fig. 4 illustrates the adsorption/desorption cycle of water vapour for a reference material, which, in the example given, is pristine (respectively curve 9 and 10). The reference material may be seen as a porous material before damaging by means of etching and/or stripping. Insignificant water adsorption in the pristine film shown in Fig. 4 happens without bulk condensation and reflects the presence of only a small amount of centres at which water adsorption (constitutively defective) can occur. If the number of these centres is limited, the contact or wetting angle remains high because the adsorbed water molecules do not form a continuous layer on the wall surface. Fig. 4 shows that the pristine film adsorbs only 4% of water of the total film volume. Measurements on a reference material, i.e. on an undamaged porous material, are performed in order to determine damage introduced by etching and/or stripping processes and to distinguish them from constitutive hydrophilic centres, initially present in the material, from the total amount of measured centres.

However, the situation is different in the case of a damaged low-k film. The surface area of this damaged low-k film becomes hydrophilic due to loss of hydrocarbon groups and therefore the amount of adsorbed water drastically increases. The water adsorption/desorption isotherm for a damaged low-k film is also shown in Fig. 4 (respectively curve 7 and 8, as already indicated above). The water adsorption/desorption isotherm for a damaged low-k film allows to determine the adsorbed amount of water (increase of this value as a result of plasma damage) and the relative pressure that corresponds to the beginning of water condensation. This relative pressure at which water condensation starts allows the calculation of the internal contact angle using equation (4).

To determine the degree of hydrophilization (hydrophilic/hydrophobic properties) two Kelvin equations (6), (7) are combined. The first Kelvin equation (6) with values obtained after the first ellipsometric measurement with adsorptive having zero contact angle with respect to the porous material (e.g. toluene, benzene) and the second Kelvin equation (7) with values obtained after the second ellipsometric measurement with adsorptive having a contact angle of 90° or higher with respect to the porous material and having polar properties (e.g. water). Combination of the two Kelvin equations (6), (7) may be performed as described hereinafter.

$$\ln\left(\frac{P}{P_0}\right) = -\cos\theta * \frac{\gamma V_L}{RT} * \left(\frac{2}{r}\right) \tag{3}$$

$$\ln\left(\frac{P}{P_0}\right)_{a1} = -\frac{\gamma_{a1} V_{La1}}{RT} * \left(\frac{2}{r}\right) \tag{6} \qquad \ln\left(\frac{P}{P_0}\right)_{a2} = -\cos\theta * \frac{\gamma_{a2} V_{La2}}{RT} * \left(\frac{2}{r}\right) \tag{7}$$

Combination of these Kelvin equations (6) and (7) allows to calculate the effective "contact angle" of the adsorptive or gaseous substance with "90° or higher" contact angle, in the example given water, with respect to the porous material. The effective contact or wetting angle gives information about surface energy, which is correlated to the hydrophilic properties of the porous material. The contact angle is a measure for the surface energy. The equilibrium situation is expressed by Young's equation:

$$\gamma_{SV} - \gamma_{SL} = \gamma_{LV} \cos\theta , \qquad\qquad (8)$$

wherein $\gamma SV$, $\gamma SL$, and $\gamma LV$, respectively are the surface energy of the solid, the surface energy of the interface and the surface energy of water. By means of equation (8) only the difference between the two quantities at the left hand side can be determined. In order to separate these two quantities, i.e. to separate surface energy from the solid and the interface, certain models, based on independent knowledge of how liquids and solids adhere together have to be used. Such models are described in e.g. 'W. A. Zisman, Advanc. Chem. Ser. 43 (1964), 1'; 'L.A. Girifalco et al., J. Phys. Chem. 61, 904-909, (1957)'; D. K. Owens and R. C. Wendt, J. Appl. Polym. Sci. 13, 1741, (1969), L. Zusne, The harmonic mean as a model, American Psychologist 31, 805-807, (1976)' or 'G. Lewis, Thermodynamics and the free energy of chemical substances, (1923)'.

Equation (6) is the Kelvin equation for the first adsorptive or gaseous substance with a first contact or wetting angle being substantially equal to zero. Equation (7) is the Kelvin equation for the second adsorptive or gaseous substance with a second contact or wetting angle being 90° or higher. In equation (6) and (7) the subscripts a1 and a2 respectively stand for the first adsorptive or gaseous substance and the second adsorptive or gaseous substance. The result of the combination of equation (6) and (7) is:

$$\theta = \arccos\left\{\left[\ln\left(\frac{P}{P_0}\right)_{a2} \Big/ \ln\left(\frac{P}{P_0}\right)_{a1}\right]\left(\frac{\gamma_{a1} V_{La1}}{\gamma_{a2} V_{La2}}\right)\right\} \qquad\qquad (9)$$

The method for the determination of the effective contact angle as described above allows to determine the value of this contact angle which can't be measured by any other method. Moreover, the effective contact angle directly reflects the hydrophilic/hydrophobic properties that are important for the k-value of the porous material, e.g. low-k material. The difference between the method of the invention and state of the art techniques such as TOFSIMS/XPS is that the method of this invention does not need any assumption like identity of the carbon depletion and degree of hydrophilization. Furthermore, the method according to the first embodiment of the invention is not destructive. This is in contrast with the existing prior art methods.

Hence, according to the invention, determination of the hydrophilic/hydrophobic properties of porous materials, e.g. the low-k films having pores, at least two ellipsometric measurements with use of a first and second adsorptive, each having a different contact or wetting angle with respect to the porous material, are required. Most preferred these ellipsometric measurements may be ellipsometric measurements performed at pressures changing from zero to the equilibrium vapour pressure of the adsorptives used.

The first adsorptive is an adsorptive with a contact or wetting angle substantially equal to zero and the second adsorptive is an adsorptive with contact or wetting angle of 90° or higher comprising polar molecules. Examples of the first adsorptives (with contact angle substantially equal to zero with respect to the porous material) may, in case of low-k materials and porous membranes comprising organic molecules, be nitrogen, toluene, methanol and benzene; these adsorptives show good wettability with porous materials such as porous low-k materials and porous membranes comprising organic molecules. An example of the second adsorptives with contact or wetting angle of 90° or higher with respect to low k-materials or porous membranes comprising organic molecules is water, $SOCl_2$ or any other suitable inorganic solvent having a contact angle of 90° or higher towards low-k materials and porous membranes comprising organic molecules.

In a second embodiment according to the present invention a method for determining the depth of damage in a porous material, e.g. a low-k film is provided.

A method is disclosed to determine the internal surface energy or effective contact angle, degree and depth of damage in a porous material, such as e.g. a low-k material, and more specifically to determine the depth of damage within a porous material such as e.g. a low-k material after plasma etch and/or strip processing. Plasma damage is defined here as a loss of hydrophobicity of the porous material, e.g. low-k material, due to loss of organic hydrophobic groups, e.g. in case of low-k materials hydrocarbon groups. The damage may be originating from plasma etch and/or strip processing of the porous material, e.g. low-k material.

To determine the depth of damage within a porous material, e.g. a film formed of a porous material, e.g. a low-k film, the porous film, e.g. low-k film, is to be considered as a two-layered system comprising two layers with different properties. The first or top layer reflects the damaged area of the porous film, e.g. low-k film. The first or top layer is more hydrophilic than the second or bulk layer of the porous film, e.g. low-k film. The bulk layer is considered not to be damaged. Taking into account this fact, the depth of plasma damage within a porous film, e.g. a low-k film, may be determined.

The amount of adsorbed water within the pores of the porous material, e.g. low-k material, as discussed in the first embodiment of this invention, may further be used in this second embodiment of the invention to calculate the degree of damage and more specifically to calculate the depth of damage within the porous film, e.g. low-k film.

To determine the depth of damage within a damaged low-k film according to the second embodiment of the present invention, at least three ellipsometric measurements are needed to determine the adsorption characteristics within the pores of the porous film at pressures ranging from zero to the equilibrium vapour pressure of said gaseous substances. To perform these ellipsometric measurements a substrate having the porous film, e.g. low-k film, on top of it is located in a pressurizable chamber filled with the first adsorptive or gaseous substance. Thereafter, the second measurement is performed in the same way but now in a pressurizable chamber filled with the second adsorptive or gaseous substance.

The method according to the second embodiment of the invention comprises the same steps as the method described in the first embodiment of the invention. However, the method according to the second embodiment of the invention furthermore comprises a third step performed on the undamaged material.

Similar to the first embodiment of the invention, the different steps are performed by ellipsometric measurements.

For the first ellipsometric measurement performed on the undamaged porous material, e.g. a low-k film, a first adsorptive or gaseous substance is used with a first contact or wetting angle towards the porous material which is substantially equal to zero, such that the porosity and/or pore size of the porous film, e.g. low-k film, can be obtained. With substantially equal to zero is meant that the first contact or wetting angle may be lower than 5°, preferably lower than 3° and most preferably lower than 1°. Determination of pore size in adsorption porosimetry (Ellipsometric Porosity or EP measurement is one of them) is based on the Kelvin equation (2) that correlates the relative pressure with the pore radius. To make these measurements reliable, adsorptives or gaseous substances with a contact or wetting angle substantially equal to zero with respect to the porous film surface are used. Examples of these adsorptives are nitrogen, toluene, methanol and benzene. In this case $\cos\theta = 1$ (because $0 = 0°$) in the Kelvin equation (3) and adsorption/desorption cycle allows to calculate the volume of adsorbed toluene (open pores volume). Preferably the contact or wetting angle of the chosen adsorptive or gaseous substance may be substantially the same for both the reference non-damaged material, e.g. pristine, and the damaged low-k material. The obtained value from this measurement is also referred to as $P_{a1}$ or porosity of the porous film, e.g. low-k film, measured by an adsorptive or gaseous substance with contact or wetting angle substantially equal to zero.

For the second ellipsometric measurement performed on a damaged porous film, e.g. low-k film, a second adsorptive or gaseous substance is used with a second contact or wetting angle towards the porous material. The second adsorptive comprises polar molecules such that the adsorption of the second gaseous substance within the pores of said damaged low-k film can be measured. The second gaseous substance or adsorptive has a contact angle equal to or higher than 90°. Most preferred the second gaseous substance may be water, $SOCl_2$ and any other suitable inorganic solvent having a contact angle of 90° or higher towards low-k materials and porous membranes comprising organic molecules.

The value
obtained from this second ellipsometric measurement is referred to as $P_{a2,1}$ or porosity of the damaged porous film, e.g. low-k film, measured by the second adsorptive or gaseous substance, e.g. water or other polar substances.

The third ellipsometric measurement is performed on the undamaged low-k film, i.e. on the porous material before it is submitted to etching and/or stripping processes, with almost no hydrophilic properties with the second gaseous substance with second contact or wetting angle towards the porous material being 90° or higher, such that the adsorption of the second gaseous substance within the pores of said reference low-k film can be obtained. Most preferred said second gaseous substance is water. The value obtained from this third ellipsometric measurement is referred to as $P_{a2,2}$ or porosity of the undamaged low-k film measured by water or other polar substances. The three ellipsometric measurements described above are combined in the following equation (5), which is then used to determine the depth of damage within a low-k film:

$$P_{a2,2} * d_0 = P_{a1} * d + P_{a2,1} * (d_0 - d) \qquad (10)$$

wherein $P_{a2,2}$ is the porosity (volume of the adsorbed liquid) of the damaged porous film, e.g. low-k film, measured by a polar gaseous substance, $P_{a2,1}$ is the porosity (volume of the adsorbed liquid) of the porous film, e.g. low-k film, before damage (measured by water); $P_{a1}$ the porous film, e.g. tow-k film, porosity measured by toluene; $d_0$ is the film thickness and d is the depth of wetting.

Summarised, the value $P_{a1}$ is obtained from the first ellipsometric measurement performed on the low-k film with a first gaseous substance with contact or wetting angle towards the porous material substantially equal to zero such that the porosity and/or pore size of the low-k film can be obtained. Preferably the first adsorptive is nitrogen, toluene, methanol or benzene. The value $P_{a2,2}$ is obtained from the second ellipsometric measurement performed on the damaged low-k film with a second adsorptive or gaseous substance with polar molecules. Most preferred said second adsorptive or gaseous substance is water. The value $P_{a2,1}$ is obtained from the third ellipsometric measurement performed on the undamaged low-k film (before plasma etch and/or stripping) with the second adsorptive or gaseous substance with polar molecules. Most preferred said second gaseous substance is water.

Hereinafter, some examples illustrating the method according to the present invention will be described.

Example 1: Determination of the amount of water adsorbed in a porous low-k film

Fig. 5A-5E show adsorption/desorption isotherms for an undamaged reference low-k material (pristine) and a SiOC(H) low-k material (NCS) after different plasma etch processes.

Figure 5A shows the amount of water absorbed in an undamaged reference low-k material, also referred to as pristine. Insignificant water adsorption in the reference material, in the example given a pristine film, occurs without bulk condensation and reflects only the presence of a small amount of water adsorption centres. If the number of these centres is limited, the contact angle remains high because the adsorbed water molecules do not form continuous layer on the wall surface. This figure shows that the film adsorbs only 4% of water in respect to the film volume.

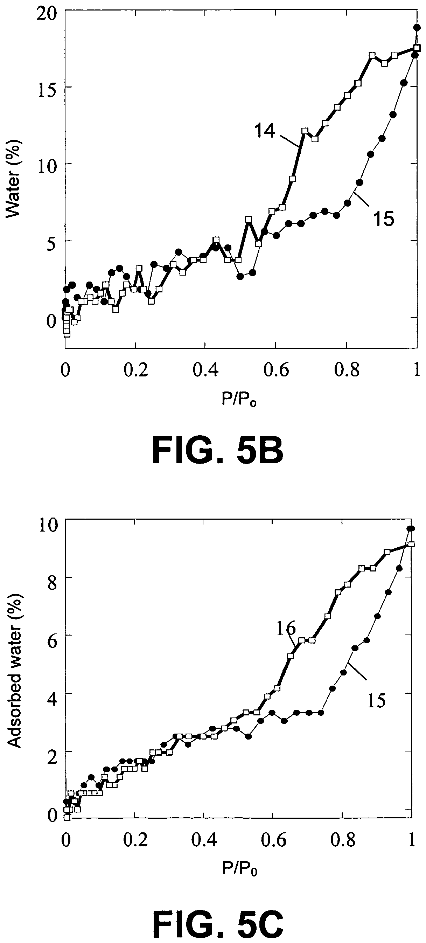

Figure 5B shows the amount of water absorbed in a SiOC(H) low-k material (NCS) after $CF_4/O_2$ plasma etch. The amount of water absorbed in the low-k film due to plasma damage is 18%.

Figure 5C shows the amount of water absorbed in a SiOC(H) low-k material (NCS) after $C_4F_8$ plasma etch. The amount of water absorbed in the low-k film due to plasma damage is 9.5%.

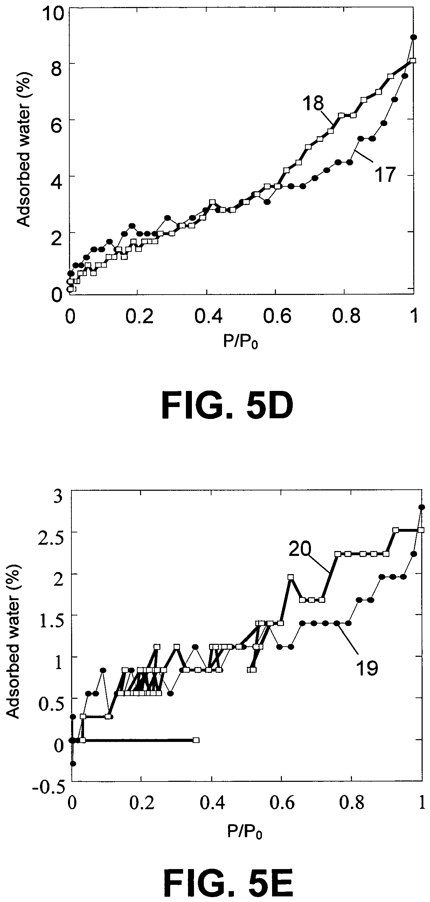

Figure 5D shows the amount of water absorbed in a SiOC(H) low-k material (NCS) after $CF_4$ standard plasma etch. The amount of water absorbed in the low-k film due to plasma damage is 9%.

Figure 5E shows the amount of water absorbed in a SiOC(H) low-k material (NCS) after HMDS treatment. The amount of water absorbed in the low-k film due to plasma damage is 2.7%.

Example 2: Determination of the degree and depth of damage in a porous low-k film

A porous low-k material deposited onto a wafer is subjected to a standard etch process for anisotropically etching vias and trenches for interconnect processing (e.g. to create (dual) damascene structures). The etch plasma used in this example comprises $CF_4$, $O_2$, $N_2$ and Ar.

Using the method of the invention and following equation the depth of damage within a low-k film can be obtained:

$$P_{a2,2} * d_0 = P_{a1} * d + P_{a2,1} * (d_0 - d) \qquad (11)$$

where $P_{a2,2}$ is the porosity of the damaged low-k film measured by the second adsorptive, in the example given water; $P_{a2,1}$ is porosity of the low-k film before damage (measured by the second adsorptive, in the example given water); $P_{a1}$ the low-k film porosity measured by the first adsorptive, in the example given toluene; $d_0$ is the film thickness and $d$ is the depth of wetting. The value $P_{a1}$ is obtained from the first ellipsometric measurement performed on the low-k film with the first adsorptive, in the example given, toluene such that the porosity and/or pore size of the low-k film can be obtained. The value $P_{a2,2}$ is obtained from the second ellipsometric measurement performed on the damaged low-k film with the second adsorptive, in the example given water. The value $P_{w1}$ is obtained from the third ellipsometric measurement performed on the undamaged low-k film (before plasma etch and strip) with the second adsorptive, in the example given water.

Results of the ellipsometric measurements give a $P_{a2,2}$ value of 14.2%, a $P_{a2,1}$ value of 4.2% and a $P_{a1}$ value of 30%. By using the Lorentz-Lorentz equation:

$$\frac{n_{rl}^2 - 1}{n_{rl}^2 + 2} = V \frac{n_{ads}^2 - 1}{n_{ads}^2 + 2} + (1 - V)\frac{n_2^2 - 1}{n_2^2 + 2} \qquad (12)$$

wherein $n_{rl}$, $n_{ads}$ and $n_2$ are refractive indices of respectively the film with adsorbed water, water and the film itself, and V is the volume of adsorbed water. By dividing the value obtained by equation (12) by the volume of the film and multiply this with 100, a damage of 38.5% is obtained. This means that 38.5% of the total low-k film thickness is damaged.

The effective contact angle, determined by means of equation (9) is 40 degrees.

It is to be understood that although preferred embodiments, specific constructions and configurations, as well as materials, have been discussed herein for devices according to the present invention, various changes or modifications in form and detail may be made without departing from the scope of the appended claims.

**Claims**

1. A method for the quantification of hydrophilic properties of a porous material, the method comprising

   - performing a first ellipsometric porosimetry measurement on said porous material using a first adsorptive having a first wetting angle which is substantially equal to zero, thereby obtaining values of a first Kelvin equation (6)

$$\ln\left(\frac{P}{P_0}\right)_{a1} = -\frac{\gamma_{a1}V_{La1}}{RT} * \left(\frac{2}{r}\right) \quad (6)$$

   - performing a second ellipsometric porosimetry measurement on said porous material using a second adsorptive having a second wetting angle which is 90° or higher and which comprises polar molecules, thereby obtaining values of a second Kelvin equation (7)

$$\ln\left(\frac{P}{P_0}\right)_{a2} = -\cos\theta * \frac{\gamma_{a2}V_{La2}}{RT} * \left(\frac{2}{r}\right) \quad (7) \quad,$$

   and
   - quantifying the hydrophilic properties of the porous material from a combination of the at least first and second measurement by combining equation (6) and (7), thereby calculating the effective contact angle of the second adsorptive as being equal to

$$\theta = \arccos\left\{\left[\ln\left(\frac{P}{P_0}\right)_{a2} \middle/ \ln\left(\frac{P}{P_0}\right)_{a1}\right]\left(\frac{\gamma_{a1}.V_{La1}}{\gamma_{a2}.V_{La2}}\right)\right\}$$

   Wherein P is the vapor pressure, $P_0$ is the equilibrium vapor pressure, the subscripts a1 and a2 respectively stand for the first adsorptive and the second adsorptive, and $r$, $\gamma$ and $V_L$ respectively are the average radius of the pores present in the porous material, the surface tension and the molar volume of the adsorptive.

2. A method according to claim 1, the method furthermore comprising performing a third ellipsometric porosimetry measurement on said porous material before damage treatment using said second adsorptive having a second wetting angle toward the porous material.

3. The method according to claim 1 or claim 2, wherein the first wetting angle is smaller than 5°, preferably smaller than 3° and most preferably smaller than 1 °.

4. The method according to claim 3, wherein the first adsorptive is any of nitrogen, toluene, methanol or benzene.

5. The method according to any of the previous claims, wherein the second adsorptive is any of water, $SOCl_2$ or any other inorganic solvent having a contact angle of 90° or higher toward low-k materials and porous membranes.

6. The method according to any of the previous claims, wherein said porous material is a low-k material having pores.

**Patentansprüche**

1. Verfahren zur Quantifizierung der hydrophilen Eigenschaften eines porösen Materials, wobei das Verfahren umfasst:

   - Durchführen einer ersten ellipsometrischen Porosimetriemessung an dem porösen Material unter Verwendung eines ersten Adsorptionsmittels in einem ersten Benetzungswinkel, der im Wesentlichen gleich Null ist, dadurch Erhalten von Werten einer ersten Kelvin-Gleichung (6)

$$\ln\left(\frac{P}{P_0}\right)_{a1} = -\frac{\gamma_{a1}V_{La1}}{RT} * \left(\frac{2}{r}\right) \quad (6)$$

- Durchführen einer zweiten ellipsometrischen Porosimetriemessung an dem porösen Material unter Verwendung eines zweiten Adsorptionsmittels in einem zweiten Benetzungswinkel von 90° oder mehr und das polare Moleküle umfasst, dadurch Erhalten von Werten einer zweiten Kelvin-Gleichung (7)

$$\ln\left(\frac{P}{P_0}\right)_{a2} = -\cos\theta * \frac{\gamma_{a2}V_{La2}}{RT} * \left(\frac{2}{r}\right) \quad (7) \quad,$$

und

- Quantifizieren der hydrophilen Eigenschaften des porösen Materials aus einer Kombination der mindestens ersten und zweiten Messung durch Kombinieren der Gleichungen (6) und (7), dadurch Berechnen des effektiven Kontaktwinkels des zweiten Adsorptionsmittels als gleich

$$\theta = \arccos\left\{\left[\ln\left(\frac{P}{P_0}\right)_{a2} \Big/ \ln\left(\frac{P}{P_0}\right)_{a1}\right]\left(\frac{\gamma_{a1}.V_{La1}}{\gamma_{a2}.V_{La2}}\right)\right\}$$

wobei P der Dampfdruck ist, $P_0$ der Äquilibriumsdampfdruck ist, die Tiefzahlen a1 und a2 jeweils für das erste Adsorptionsmittel und das zweite Adsorptionsmittel stehen und r, $\gamma$ und $V_L$ der durchschnittliche Radius der Poren, die in dem porösen Material vorhanden sind, die Oberflächenspannung bzw. das molare Volumen des Adsorptionsmittels sind.

2. Verfahren nach Anspruch 1, wobei das Verfahren weiterhin das Durchführen einer dritten ellipsometrischen Porosimetriemessung an dem porösen Material vor der Schadensbehandlung unter Verwendung des zweiten Adsorptionsmittels in einem zweiten Benetzungswinkel in Richtung des porösen Materials umfasst.

3. Verfahren nach Anspruch 1 oder Anspruch 2, wobei der erste Benetzungswinkel kleiner als 5° ist, vorzugsweise kleiner als 3° und am meisten bevorzugt kleiner als 1° ist.

4. Verfahren nach Anspruch 3, wobei das erste Adsorptionsmittel eines von Stickstoff, Toluol, Methanol oder Benzol ist.

5. Verfahren nach einem der vorstehenden Ansprüche, wobei das zweite Adsorptionsmittel Wasser, $SOCl_2$ oder ein anderes anorganisches Lösungsmittel mit einem Kontaktwinkel von 90° oder mehr zu Low-K-Materialien und porösen Membranen ist.

6. Verfahren nach einem der vorstehenden Ansprüche, wobei das poröse Material ein Low-K-Material mit Poren ist.

**Revendications**

1. Procédé de quantification des propriétés hydrophiles d'un matériau poreux, le procédé comprenant

- la réalisation d'une première mesure ellipsométrique de porosité sur ledit matériau poreux en utilisant une première adsorptive ayant un premier angle de mouillage qui est sensiblement égal à zéro, permettant ainsi d'obtenir les valeurs d'une première équation de Kelvin (6)

$$\ln\left(\frac{P}{P_0}\right)_{a1} = -\frac{\gamma_{a1}V_{La1}}{RT} * \left(\frac{2}{r}\right) \quad (6)$$

- la réalisation d'une seconde mesure ellipsométrique de porosité sur ledit matériau poreux en utilisant une seconde adsorptive ayant un second angle de mouillage qui est de 90° ou plus et qui comprend des molécules polaires, permettant ainsi d'obtenir les valeurs d'une seconde équation de Kelvin (7)

$$\ln\left(\frac{P}{P_0}\right)_{a2} = -\cos\theta * \frac{\gamma_{a2} V_{La2}}{RT} * \left(\frac{2}{r}\right) \quad (7) \quad ,$$

et

- la quantification des propriétés hydrophiles du matériau poreux à partir d'une combinaison des au moins première et seconde mesures par combinaison des équations (6) et (7), permettant ainsi de calculer l'angle de contact efficace de la seconde adsorptive comme étant égal à

$$\theta = \arccos\left\{\left[\ln\left(\frac{P}{P_0}\right)_{a2} \Big/ \ln\left(\frac{P}{P_0}\right)_{a1}\right]\left(\frac{\gamma_{a1}.V_{La1}}{\gamma_{a2}.V_{La2}}\right)\right\}$$

dans laquelle P est la pression vapeur, $P_0$ est la pression vapeur d'équilibre, les indices a1 et a2 représentent respectivement la première adsorptive et la seconde adsorptive, et r, $\gamma$ et $V_L$ sont respectivement les rayons moyens des pores présents dans le matériau poreux, la tension de surface et le volume molaire de l'adsorptive.

2. Procédé selon la revendication 1, le procédé comprenant en outre la réalisation d'une troisième mesure ellipsométrique de porosité sur ledit matériau poreux avant le traitement des dommages en utilisant ladite seconde adsorptive ayant un second angle de mouillage envers le matériau poreux.

3. Procédé selon la revendication 1 ou la revendication 2, dans lequel le premier angle de mouillage est inférieur à 5°, de préférence inférieur à 3° et idéalement inférieur à 1°.

4. Procédé selon la revendication 3, dans lequel la première adsorptive est l'un quelconque de l'azote, du toluène, du méthanol ou du benzène.

5. Procédé selon l'une quelconque des revendications précédentes, dans lequel la seconde adsorptive est l'une quelconque de l'eau, du $SOCl_2$ ou tout autre solvant inorganique ayant un angle de contact de 90° ou plus envers les matériaux à faible constante et les membranes poreuses.

6. Procédé selon l'une quelconque des revendications précédentes, dans lequel ledit matériau poreux est un matériau à faible constante ayant des pores.

## FIG. 1 – PRIOR ART

## FIG. 2

## FIG. 3

**FIG. 4**

**FIG. 5A**

**FIG. 5B**

**FIG. 5C**

**FIG. 5D**

**FIG. 5E**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **QUOC TOAN LE et al.** *Electrochem.Sol.-St.Lett.,* 2005, vol. 8 (7), F21
- **A. BOURGEOIS et al.** Description of the porosity of inhomogeneous porous low-k films using solvent adsorption studies by spectroscopic ellipsometry in the visible range. *Thin Solid Films,* 2004, vol. 455-456, 366-369
- **F.N. DULTSEV et al.** Nondestructive determination of pore size distribution in thin films deposited on solid substrates. *Electrochemical and Solid-State Letters,* 1999, vol. 2 (4), 192-194
- **G. MANNAERT et al.** Minimising plasma damage and in situ sealing of ultra low-k dielectric films by using of oxygen free fluorocarbon plasma. *J. Vac. Sci. Technol.,* 2005, vol. B23 (5
- The Optics Source Book. McGraw-Hill, 1988
- **W. A. ZISMAN.** *Advanc. Chem. Ser.,* 1964, vol. 43, 1
- **L.A. GIRIFALCO et al.** *J. Phys. Chem.,* 1957, vol. 61, 904-909
- **D. K. OWENS ; R. C. WENDT.** *J. Appl. Polym. Sci.,* 1969, vol. 13, 1741
- **L. ZUSNE.** The harmonic mean as a model. *American Psychologist,* 1976, vol. 31, 805-807
- **G. LEWIS.** *Thermodynamics and the free energy of chemical substances,* 1923